(19) Europäisches Patentamt
European Patent Office
Office européen des brevets

(11) **EP 4 722 700 A1**

(12) **EUROPEAN PATENT APPLICATION**

(43) Date of publication:
08.04.2026 Bulletin 2026/15

(21) Application number: 25206691.5

(22) Date of filing: 03.10.2025

(51) International Patent Classification (IPC):
*G01N 23/2251* (2018.01)  *H01J 37/26* (2006.01)

(52) Cooperative Patent Classification (CPC):
**G01N 23/2251; H01J 37/222; H01J 37/26**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 03.10.2024 US 202463703085 P

(71) Applicant: **FEI COMPANY**
**Hillsboro, OR 97124 (US)**

(72) Inventors:
• **FRANKEN, Erik**
**Nuenen (NL)**
• **JANSSEN, Bart Jozef**
**Lent (NL)**

(74) Representative: **Boult Wade Tennant LLP**
**Salisbury Square House**
**8 Salisbury Square**
**London EC4Y 8AP (GB)**

(54) **DARK CORRECTION FOR LONG TERM ACQUISITION**

(57)    A charged particle beam (CPB) imaging apparatus intermittently acquires dark frames while the CPB is blanked and updates a dark reference with the intermittently acquired dark frames. The dark reference is used to compensate additive noise components in acquired sample frames, especially additive noise that increases during multiple image acquisitions over extended time periods.

**EP 4 722 700 A1**

## Description

### FIELD

The present disclosure is directed to charged particle beam (CPB) imaging.

### BACKGROUND

Some CPB imaging apparatus applications requiring lengthy acquisitions based on acquisition of large numbers of sample images over extended times, for example, tomographic imaging electron microscopy. These sample images can be corrected for the presence of additive noise components (e.g., 1/f and/or random telegraph signal (RTS) noise) by using a dark reference to compensate the sample images. In some examples the dark reference comprises a combination of dark frames taken before or after the sample images are acquired. One difficulty with these conventional approaches is that during image acquisition the additive noise levels change and a dark reference acquired before or after image acquisition is not indicative of actual noise during image acquisition. For relatively short exposures, this is usually not an issue, but for longer exposures (e.g., a 30 second tomography run), such dark references are not suitable. In addition, in some cases sample images are used for feature tracking, a process by which artificial features, like gold markers or recognizable intrinsic specimen features, are used as a basis for image alignment. When sample images are used for feature tracking, fixed pattern noise associated with additive noise components can be erroneously processed to indicate that features of interest are unshifted in the sample images. For these and other reasons, alternative approaches are needed.

### SUMMARY

Described herein are charged particle beam (CPB) imaging apparatus and methods for acquiring sample images and compensating images based on dark reference frames.

A CPB imaging apparatus may include a CPB source operable to irradiate a sample with a CPB; a beam blanker operable to selectively direct the CPB to the sample; and a detection system operable to acquire a sequence of frames that includes a first set of sample frames, a second set of sample frames, a first set of dark frames, and a second set of dark frames respectively, wherein the first set of sample frames and the second set of sample frames are associated with operation of the beam blanker to irradiate the sample with the CPB and the first set of dark frames and the second set of dark frames are associated with operation of the beam blanker to divert at least a portion of the CPB from the sample. The dark frames can be used to define a dark reference or be used as a dark reference to reduce detector noise.

Using the CPB imaging apparatus may include acquiring a first set of one or more sample frames associated with a sample; compensating the first set of one or more sample frames based on a first dark reference to produce a first set of one or more compensated sample frames; acquiring a second set of one or more sample frames; after acquiring the first set of one or more frames, acquiring one or more dark frames, wherein the one or more dark frames are acquired before, after, or both before and after the acquisition of the second set of one or more sample frames; updating the first dark reference based on the one or more acquired dark frames to create a second dark reference; and compensating the second set of one or more frames based on the second dark reference to produce a second set of one or more compensated sample frames.

The foregoing and other objects, features, and advantages of the present disclosure will become more apparent from the following detailed description, which proceeds with reference to the accompanying figures.

### BRIEF DESCRIPTION OF THE DRAWINGS

FIG. 1 illustrates a representative charged particle beam (CPB) imaging system configured to update a dark reference.

FIGS. 2A-2C illustrate the effect of noise such as 1/f noise on image quality in long term image acquisitions.

FIG. 2D illustrates example sequences illustrating acquisition of sample frames, dark frames, and updating of dark references.

FIG. 3 illustrates a representative method of dark correction in which a dark reference is updated.

FIGS. 4A-4B illustrate representative methods of dark correction in which dark frames are acquired during interpulse periods.

FIGS. 5A-5B illustrate acquisition of dark frames and image frames using subsets of detector pixels.

FIG. 6 illustrates a representative method of acquiring sample frames and dark frames using subsets of detector pixels.

FIG. 7 is a block diagram representing an exemplary computing system or operating environment in which the various disclosed embodiments can be implemented.

## DETAILED DESCRIPTION

Disclosed herein are methods and apparatus for charged particle beam (CPB) imaging, such as CPB tomography. In CPB tomography, a sample is typically situated on a rotatable sample stage for repetitive exposure to a CPB at a plurality of angles. The disclosed examples are generally described with reference to transmission electron microscopy for use in tomographic reconstruction, but other CPBs and other types of imaging can be used. Alternatively, samples can be irradiated with X-rays and X-ray based images acquired.

According to some aspects of the disclosure, during CPB imaging, for example, transmission electron microscopy (TEM), an image correction takes place which converts raw data from the detector into frames that can be used for further processing such as "dark correction." Dark correction can compensate the frames for additive noise components that are present in the detector data (e.g., 1/f and/or RTS noise). To accomplish this correction, a few dark frames are usually collected before and sometimes after the sample is exposed to the CPB. These dark frames can be combined to create a dark reference, which is subsequently used for compensating the sample frames. While it is possible for a single dark frame to be used to create a dark reference, in some examples, multiple dark frames can be combined to create the dark reference. In some examples, it is desirable for an improved dark reference to be created by averaging multiple dark frames. In some examples, as will be understood from the disclosure below, the dark frames can each be assigned a weighting factor (e.g., with respect to time and/or with respect to additive noise levels) and the dark reference comprises a weighted average of dark frames.

### General Considerations

As used herein, "column" or "optical column" refers generally to one or more CPB optical elements or combinations of elements such as CPB sources, CPB lenses, CPB deflectors, CPB apertures, stigmators, or other CPB optical elements. One or more of such optical elements can be used to produce a pulsed CPB that can be directed to a sample to provide a pulsed exposure. Such pulsed exposures are generally referred to as "stroboscopic" exposures to indicate that effective exposure times are sufficiently short with respect to sample rotation that suitable images are produced, i.e., without undue motion-induced blurring. Suitable exposure times can correspond to rotations of less than 0.0001, 0.001, 0.01 degrees or other angles. Specification of any permitted maximum exposure duration can depend on image magnification and intended resolution. In stroboscopic exposures, a CPB may have a continuous component in addition to the stroboscopic component. In many practical examples, pulsed exposures are preferred in order to reduce sample degradation produced by CPB exposures that include a continuous component. A continuous component can contribute to undesirable sample changes without improving tomographic imagery.

The term "image" is used herein to refer to displayed image such as on a computer monitor, or digital or analog representations that can be used to produce displayed images. Digital representations can be stored in a variety of formats such as JPEG, TIFF, or other formats. Image signals can be produced using an array detector or a single element detector along with suitable scanning of a sample. In most practical examples, images produced with a detector are two-dimensional, such as a two-dimensional array of pixels. In some examples, an image may be three-dimensional. In some examples, an image may be a compound image constructed of multiple images. In one example, the compound image may comprise a tomographic reconstruction of the sample.

The term "frame" is used herein to refer to data which is associated with a detector, and can be used as or to form an image or to compensate an image. As used herein, a "sample frame" refers to a frame based on exposure of a sample to a CPB and "dark frame" refers to a frame obtained without (or with reduced) exposure to a CPB, typically by blocking or attenuating a CPB that would otherwise be directed to a sample. In most practical examples, frames are two-dimensional arrays of pixels and in many cases are obtained with array detectors, particularly in TEM. In most cases, frames contain image data as two-dimensional data arranged in rows and columns. The term "subframe" may be used to describe a part of a frame, such as, for example, a one-dimensional line of pixels in a two-dimensional frame or other portion of a frame.

In some cases, the detectors used to produce sample frames include arrays of pixels, each of which stores charge in response to exposure of a sample S to a CPB. Due to this charge storage, a sample frame can be obtained from a detector even after the CPB is blanked, at least for a time period associated with a charge storage time constant. In addition, with such charge storage, acquisition of a dark frame is preferably timed so that any charge associated with previous CPB exposure is dissipated by, for example, being readout out as a sample frame, readout and discarded, or allowed to decay based on a device charge storage time constant. In some applications, large numbers of sample frames are acquired and switching a CPB current delivered to a sample from a higher current to a lower current (or no current) is preferably rapid. Switching a delivered CPB current from a higher current to a lower current is referred to herein generally as "blanking" and such blanking can generally be complete so that CPB current at a sample is zero. More generally, blanking can refer to reducing delivered CPB current to a specimen from a value $I$ associated with acquisition of a sample frame to less than or equal to $I/4$, $I/5$, $I/10$, $I/20$, $I/50$, or $I/100$. In the examples, blanking is illustrated using an electrostatic beam deflector but blanking can be provided with a magnetic beam deflector, a combination of electrostatic and magnetic beam deflector, direct modulation of CPB emission, focus and defocus using one or more CPB lenses, or in other ways.

As used in this application and in the claims, the singular forms "a," "an," and "the" include the plural forms unless the context clearly dictates otherwise. Additionally, the term "includes" means "comprises." Further, the term "coupled" does not exclude the presence of intermediate elements between the coupled items.

The systems, apparatus, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one of ordinary skill in the art.

In some examples, values, procedures, or apparatus are referred to as "lowest," "best," "minimum," or the like. It will be appreciated that such descriptions are intended to indicate that a selection among many used functional alternatives can be made, and such selections need not be better, smaller, or otherwise preferable to other selections.

Examples are described with reference to directions indicated as "above," "below," "upper," "lower," and the like. These terms are used for convenient description, but do not imply any particular spatial orientation.

**Example 1**

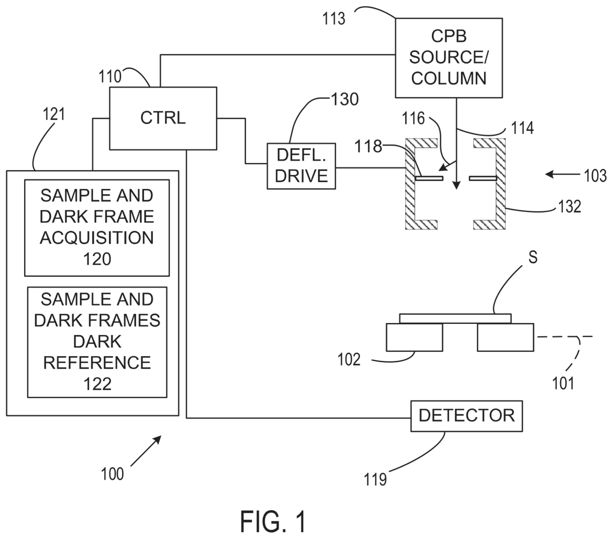

Referring to FIG. 1, a CPB microscope or other CPB imaging system 100 includes a CPB source and optical column 113 operable to irradiate a sample S with a CPB 114. A beam blanking system 103 (also referred to as a "beam blanker") is situated to interrupt, deflect, or otherwise modulate the CPB 114 at predetermined times. In some examples, the CPB source may comprise an electron beam source. In some examples, the beam blanking system 103 is operable to intermittently interrupt the CPB so that dark frames or sample frames can be acquired. As used herein, "intermittent interruption" comprises interruption at any one of periodic time intervals, random time intervals, after acquisition of a pre-determined number of sample frames, and/or at an interval determined based on size of a magnitude of noise in a dark frame, or at other times.

In some examples, the beam blanking system 103 comprises an aperture defined in an aperture plate 118 which can be used to interrupt or attenuate the CPB 114 in response to application of a deflection voltage from a deflection driver 130 to a beam deflector 132, such as a resonant beam deflector. The deflector driver 130 is actuatable to produce deflections of the CPB 114. With the beam deflector 132 activated, the CPB 114 is deflected to form a deflected beam 116 that is blocked by the aperture plate 118. In some examples, the CPB 114 is completely blocked by the aperture plate 118. In some examples, the deflected beam 116 is deflected such that only a portion of the CPB 114 is blocked by the aperture plate 118 so that the sample S is irradiated with a reduced CPB beam current. In some cases, the blanked portion of the CPB 114 irradiates a portion of the sample S that is smaller than a portion irradiated with the unblanked CPB or irradiates the same portion but with a lower CPB current density.

During the times when the CPB 114 is not deflected by the beam blanking system 103, a detection system, comprising a detector 119, is operable to acquire a sequence of sample frames associated with exposure of the sample S to the CPB 114. When the CPB 114 is deflected to form the deflected beam 116, the detector 119 is operable to acquire one or more dark frames associated with, for example, additive noise components such as background noise. As discussed above, in some cases, charge stored by the detector 119 and associated with unblanked sample irradiation is readout or otherwise removed prior to acquiring dark frames. In the example of FIG. 1, the deflected CPB 116 is completely blocked by the aperture plate 118 and the dark frames comprise only additive noise components or other signal portions that are not based on CPB irradiation. In some examples, only a portion of the deflected beam is attenuated and dark frames comprise a portion based on a sample and additive noise components together. In other examples, a deflected CPB is incident to the sample S for acquisition of sample frames and an undeflected CPB is associated with acquisition of dark frames. In still other examples, the beam blanking system is operable to provide corresponding deflections to produce both dark frames and sample frames.

The deflector driver 130 is generally coupled to a controller 110 that can initiate or regulate beam deflection. In some examples, the controller 110 may be programed to blank the CPB 114 as described above. The controller 110 is coupled to the CPB source and optical column 113 and can produce the CPB 114 as a pulsed CPB to provide stroboscopic sample exposures. The detector 119 is situated to receive charged particles or electromagnetic radiation produced in response to the CPB 114 such as scattered electrons, secondary electrons, X-rays, or other charged or neutral particles, or other electromagnetic radiation. The detector 119 is coupled to the controller 110 so that sample frames associated with CPB exposure and dark frames associated with attenuated (or no) exposure are acquired using, for example, computer-executable instructions stored in a portion 120 of a memory 121. The memory 121 also stores one or more sample frames, dark frames, dark references, and computer-executable instructions for determination of dark references in a portion 122. Such sample frames, dark frames, and dark references can be stored along with, for example, a series of exposure times, sample tilt angles, or relative phases or time differences between acquisitions. In typical examples, dark frames acquired in a sequence are averaged to produce a dark reference, but a single dark frame can be selected as a dark reference used to compensate sample frames by removing or reducing non-sample related contributions to sample frames to produce image frames (in some cases, referred to as "compensated image frames"). In some examples, compensation means reducing the magnitude of dark noise in image frames by greater than 80%, in some examples by greater than 90%, in some examples by greater than 95%, and in some examples by greater than 99%. Compensation is generally based on a pixel-by-pixel subtraction of a suitable dark reference from sample frames to produce the image frames which the controller 110 can then combine to create a compound image of the sample S. In some examples, a sample stage 102 is configured to rotate the sample S about an axis 101. Exposure times can be determined based on predetermined rotation rates of the sample S or based on a fixed or variable rotation speed of the sample stage 102. Alternatively, the controller 110 can communicate the sample frames and dark frames via a wired or wireless network to an arbitrary location for correction of noise components, tomographic processing, reconstruction, and display.

**Example 2**

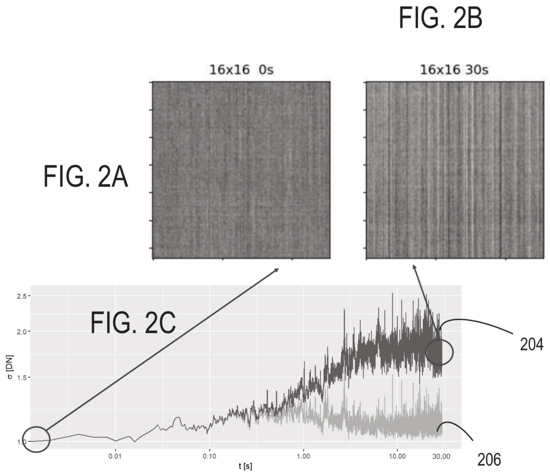

FIG. 2A-2B depict an example of a first (FIG. 2A) and a last (FIG. 2B) sample image in a 30-second acquisition using a fixed dark reference to compensate for noise, wherein the fixed dark reference was obtained prior to acquisition of the first sample frame. FIG. 2C illustrates noise associated with FIGS. 2A-2B. The stripe-pattern visible in FIG. 2B is caused by changes in noise (e.g., 1/f noise) as the frames are acquired so that compensation both fails to reduce image artifacts and introduces image artifacts. A fixed dark reference can become less useful in correcting sample frames as acquisition proceeds due to changes in additive or other noise components such as 1/f noise and random telegraph signal (RTS) noise. The fixed dark reference induces a fixed pattern in compensated sample image sequences. In some examples, the sample image sequences are used for feature tracking so that artificial features such as gold markers or recognizable intrinsic specimen features can be used as a basis for image alignment and/or to determine sample drift. When sample images using inappropriate or outdated dark references are used for tracking, the fixed pattern noise associated with the noise components can result in inaccurate tracking thereby failing to detect a shift in a sample or tracking a noise feature instead of a sample feature.

For short exposures (in some cases, about 1-10 seconds), a dark reference based on dark frames collected before acquisition can be sufficient (for example, see the image depicted in FIG. 2A, which does not exhibit the "stripe-pattern" discussed above). For longer exposures, e.g., during a 30 second tomography run, the effects of using a fixed dark reference based on, for example, dark frames collected before the acquisitions can be significant and the dark reference can induce a fixed pattern in a compensated image sequence as illustrated by vertical stripes in FIG. 2B.

FIG. 2C depicts plots 204, 206 of standard deviations versus time, t, in dark frames obtained with an exemplary charged particle detector. Plot 204 depicts data which is based on a fixed dark reference obtained prior to sample frame acquisition in the absence of sample contributions. With increasing time from a first frame for which the fixed dark reference is well-suited) the initial dark image becomes less relevant. The impact of the mismatch between the dark reference and the noise level is expected to approximately increase as the square root of elapsed time. Plot 206 depicts data based on updating a dark reference after every 32 sample frames. It can be seen that when the dark reference is updated intermittently, the impact of dark noise on sample images is reduced.

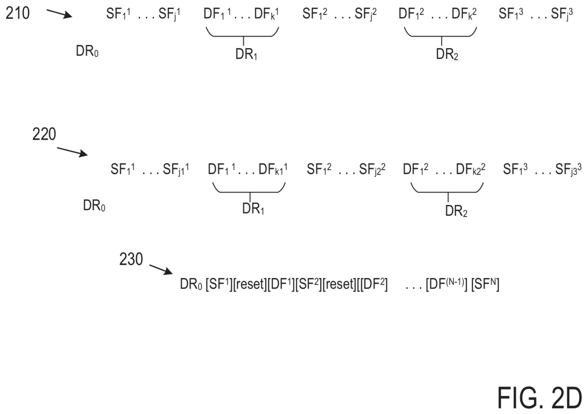

FIG. 2D illustrates representative sequences 210, 220, 230 of acquired frames that include sample frames (*SF*) and dark frames (*DF*) to be used in construction of associated dark references (*DR*) and sample images (SI). The representative sequence 210 of frames is associated with an initial dark reference $DR_0$ constructed prior to acquisition of any sample frames. The sample is exposed to a CPB to obtain sets $SF^1, SF^2, SF^3, ...$ of sample frames containing sample frames $SF_1^1 \ldots SF_j^1, SF_1^2 \ldots SF_j^2, SF_1^3 \ldots SF_j^3, \ldots$, wherein $j$ is a positive integer. The beam is blanked after acquisition of each set of sample frames to acquire respective sets $DF^1, DF^2, DF^3, ...$ of dark frames $DF_1^1 \ldots DF_k^1, DF_1^2 \ldots DF_{jk}^2, DF_1^3 \ldots DF_k^3, \ldots$, wherein $k$ is a positive integer, for use in constructing additional dark references $DR_1, DR_2, DR_3, \ldots$. In the sequence 210, each set of sample frames contains $j$ sample frames and each set of dark frames contain k dark frames acquired alternately. In some examples, one or more sets of sample frames and one or more sets of dark frames includes different numbers of frames. As shown in the representative frame sequence 220, sets $SF^1, SF^2, SF^3, \ldots$ of sample frames have $j1, j2, j3, ...$ frames, respectively, wherein $j1, j2, j3, ...$ are positive integers that can be the same or different while sets of dark frames $DF^1, DF^2, DF^3, \ldots$ have $k1, k2, k3, ...$ dark frames, respectively, wherein $k1, k2, k3. \ldots$ are positive integers that can be the same or different. In some examples, the number of frames in any particular set of dark frames or sample frames can be based on elapsed time since determination of a dark reference $DR$, at random times, based on an angular orientation of the sample, a magnitude of a change to one or more or a recently determined dark references, a technician preference, total exposure time, signal or signal to noise ratio in sample frames, or other criteria. In one example, sets of dark frames include a single dark frame and the sets of sample frames include the same number of frames.

Dark frames can be combined to create a dark reference *DR* by, for example, averaging frames in a set of dark frames or selecting a representative dark frame from a set of dark frames. A weighted average of dark frames or prior dark references can be used to construct an updated dark reference wherein dark frames or dark references temporally more distant from a sample frame are given less weight. In some examples, a spatial context can be used to construct an updated dark reference. In some examples, there can be a known spatial correlation between different pixels, this correlation can be taken advantage of to more rapidly get a low noise dark reference. In some examples, depending on exact camera chip layout, dark noise relates to digital to analog converter blocks and rows and columns and there is a known spatial correlation between different pixels which can be used to rapidly get a low noise dark reference. In some examples, it is possible to develop a model of the rate of change in the dark noise pattern which can be used for better estimations. In some examples, this modeling is primarily based on 1/f characteristics.

In some examples, the dark reference *DR* is calculated by updating a previously stored dark reference with the dark frames from a subsequently acquired set of dark frames. A dark reference can also be obtained by combining multiple dark references, typically dark references associated with sequentially acquired sets of dark frames. Sample frames in any particular set of sample frames are generally corrected using the same dark reference but need not be. For example, a subset of a sample frame set acquired at the beginning of a set can use a previously established dark reference while a subset of frames acquired at the end of a set can use a subsequently determined dark reference that includes contributions from the associated subsequent set of dark frames.

Sample frames and dark references (based on dark frames) can be used to create sample images (*SI*) by compensating a given set of one or more sample frames based on a corresponding dark reference. For example, sample frames $SF_1^2 \ldots SF_j^2$ of a set $SF^2$ of sample frames can be compensated based on $DR_1$ so that sample images $SI_1^2 \ldots SI_j^2$ are produced as $SF_1^2 - DR_1 \ldots SF_j^2 - DR_1$ and similarly for other sample frames using other dark references. In other examples, a set $SF^N$ of sample frames can be compensated based on an average such as a time weighted or other average of dark references $DR_{N-M}, ..., DR_N, ... DR_{N+L}$, wherein $M$ and $L$ are non-negative integers.

In some examples, dark frames are acquired with an attenuated but not completely blanked CPB. For example, a CPB current $I$ associated with sample irradiation for acquiring sample frames can be attenuated to $(1 - \alpha)I$, wherein $0 \leq \alpha < 1$, during acquisition of a dark frame. For sample frames and dark frames associated with common additive noise, subtraction of a dark reference from a sample frame removes the common noise but the resulting difference reduces sample image (SI) magnitude which can restored as:

$$SI = \frac{SF_a - DR}{(1-\alpha)},$$

wherein *SFa* represents a sample frame, *DR* is an associated dark reference, an $\alpha$ is defined above. For a fully blanked CPB, $\alpha = 0$ and a sample image $SI = SF_a - DR$.

Typically a plurality of sample images is obtained by compensating a plurality of sets of sample frames based on respective dark references. The compensating can be performed in real time and/or nearly real time as the sample frames are acquired as preferred for tracking sample image features during acquisition. In other examples, sample frames and dark frames are stored and sample images are produced at other times such as after acquisition of the sample frames and the dark frames.

### Example 3

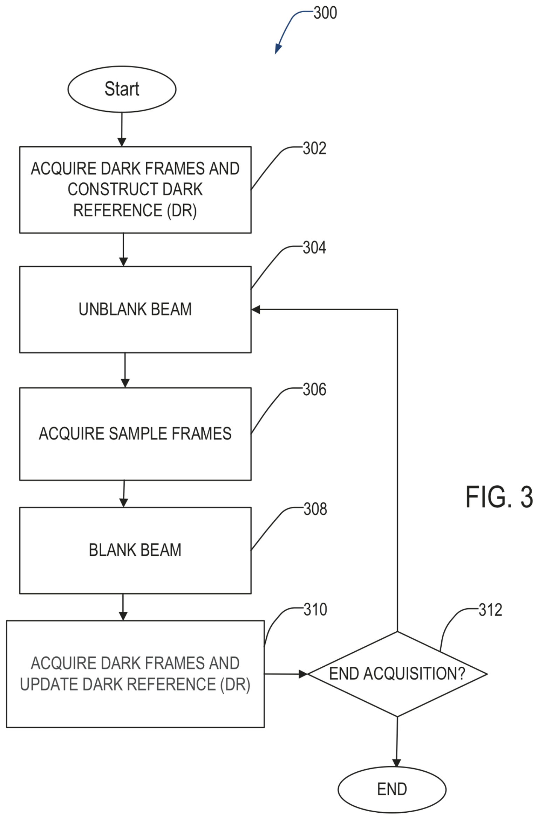

Referring to FIG. 3, a representative method 300 includes acquiring one or more dark frames and constructing a dark reference (DR) at 302. In some examples, constructing the dark reference comprises averaging the one or more dark frames. In some examples, the dark frames are associated with the additive noise levels present before any sample frames are acquired or an initial dark reference $DR_0$ can be defined as an array of zeros. At 304, the CPB is unblanked and a sample is exposed to the CPB.

At 306, while the sample is exposed to the CPB, one or more frames associated with the sample (sample frames) are acquired until a preselected criteria is met. The preselected criteria can be a predetermined number of sample frames, a fixed time interval, or any other desirable criteria. After the preselected criteria has been met, at 308 the beam is blanked again and at 310, a second set of one or more dark frames is acquired. The second set of dark frames may be a set number of one or more dark frames. The dark reference is then updated based on the these acquired dark frames.

At 312, it is determined whether the acquisition should be terminated. If acquisition is to continue, the process returns to 304. In this way, the dark reference can be intermittently updated between acquisitions of sample frames so that the dark reference can be used to effectively compensate noise in the sample frames to produce image frames. Sample images can be produced during the frame acquisitions of FIG. 3, but can also be produced upon completion of all or some acquisitions.

### Example 4

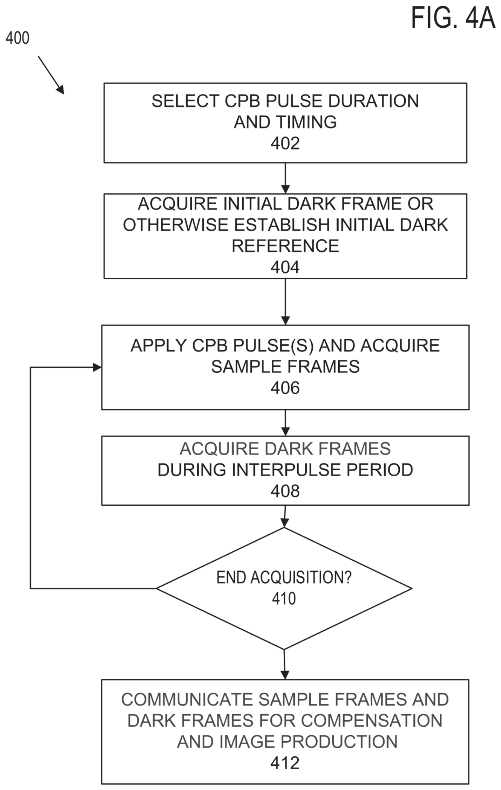

Using pulsed exposures, dark frames and sample frames can be acquired without requiring additional beam blanking. Referring to FIG. 4A, a method 400 includes selecting a CPB pulse duration and repetition rate or other CPB pulse timing at 402. At 404, an initial dark reference is established and at 406, one or more CPB pulses are applied and corresponding sample frames acquired. At 408, one or more dark frames are acquired in an interpulse period. Dark frame acquisition may require reading out stored charge in a detector based on prior pulse exposure or providing a delay for stored charge to dissipate. In some cases, after each CPB pulse and sample frame acquisition, dark frames are acquired in each interpulse period. Alternatively, dark frames can be acquired in selected pulse periods and, if needed, a pulse repetition rate can be reduced to accommodate a longer time period for acquisition of dark frames. At 410, it is determined if additional sample and dark frames are to be acquired, and if so, the method returns to 406. If acquisition is complete, sample frames and dark frames are communicated at 412. In this approach, beam blanking is associated with pulsed CPB exposures and compensation is performed after all sample frames and dark frames are acquired.

In some examples, CPB pulses are applied by pulsed deflection of a constant beam. In some examples, CPB pulses are applied by pulsed beams. In some examples, the CPB is created by photoemission and the beam pulses are a result of blanking an optical beam.

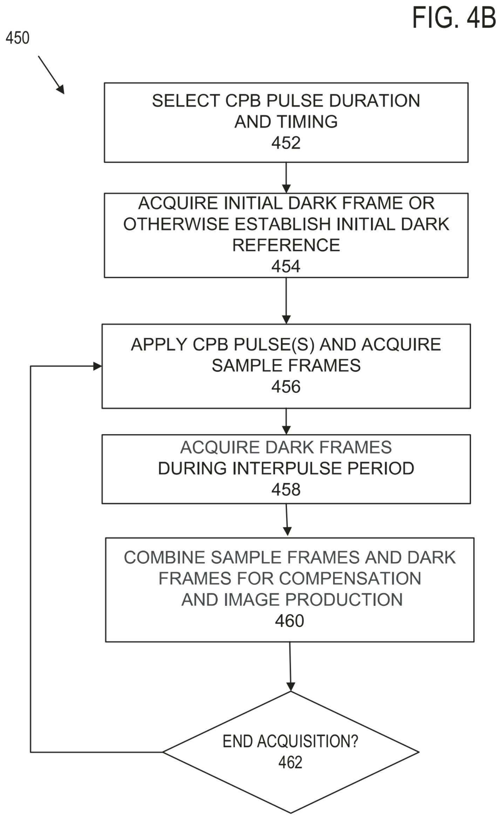

Referring to FIG. 4B a method 450 includes selecting a CPB pulse duration and repetition rate or other CPB pulse timing at 452. At 454, an initial dark reference is established and at 456, one or more CPB pulses are applied and corresponding sample frames acquired. At 458, one or more dark frames are acquired in an interpulse period. At 460, the sample frames and dark frames are combined and a compensated image is produced. In some examples, the one or more dark frames may be acquired prior to the application of one or more CPB pulses and corresponding acquisition of sample frames. In some examples, the one or more dark frames may be acquired after the application of one or more CPB pulses and corresponding acquisition of sample frames. In some examples, the one or more dark frames may be acquired before and after the application of one or more CPB pulses and corresponding acquisition of sample frames. At 462, it is determined if additional sample and dark frames are to be acquired, and if so, the method returns to 456.

### Example 5

In typical applications, a common set (usually substantially all) pixels of an array detector are used to acquire sample frames and dark frames and these frames are acquired and read-out of the array detector in different read-out operations so that both sample frames and dark frames can be referred to generally as "full" frames. If an exposed portion of a sample is imaged to a subset of detector array pixels, then read-out of a full detector array includes a sample sub-frame corresponding to the exposed portion of the sample as imaged onto the subset and a dark sub-frame corresponding to other detector array pixels (as used herein, a "complementary" set or area).

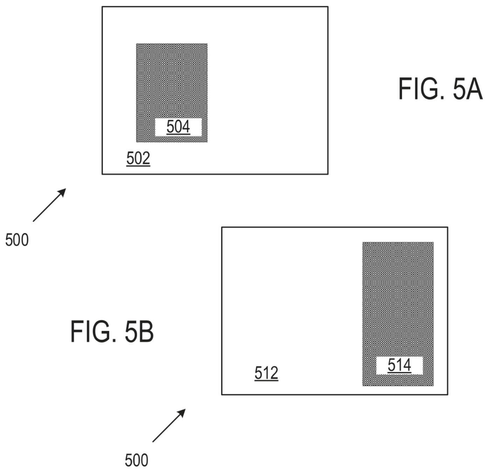

In examples in which a sample image is obtained by sequentially exposing sample areas that are less than an entire region of interest (ROI) and which are mapped to subsets of detector pixel areas, sample subset frames and dark subset frames can be obtained in a single acquisition and multiple acquisitions of different sample areas used to provide full frames. Referring to FIGS. 5A-5B, a subset 504 of pixels of a detector active surface 500 is illustrated as receiving radiation in response to irradiation of a corresponding sample area. A subset 502 of pixels is unexposed and can be used to acquire a dark subset frame. In FIG. 5B, a subset 514 of pixels of a detector surface 500 is illustrated as receiving radiation in response to irradiation of a corresponding sample area. A subset 512 of pixels is unexposed and can be used to acquire a dark subset frame. By combining multiple sample subset frames a sample frame can be produced that is associated with an entire detector active surface; by combining multiple dark subset frames, a dark frame can be produced that is associated with an entire detector active surface. The subsets of pixels can have various shapes and sizes. In this approach, a CPB is limited to exposing only a portion of a sample that is imaged to a subset of detector pixels. The CPB in this example is blanked (or shaped) to irradiate only selected areas. As discussed above, the CPB in the dark frame areas need not be completely blocked.

**Example 6**

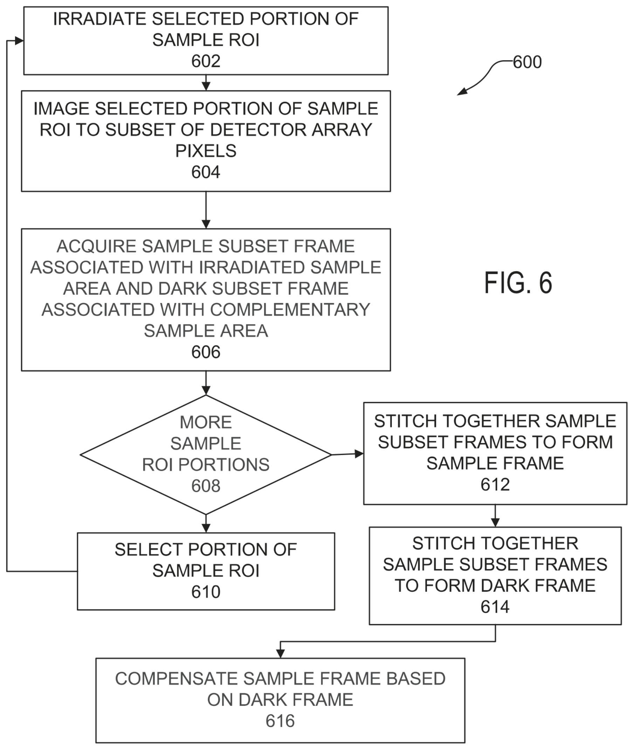

Referring to FIG. 6, a representative method 600 includes irradiating a selected portion of a sample region of interest (ROI) at 602 and imaging the selected portion to a subset of detector array pixels at 604. At 606, a sample subset frame corresponding to the irradiated sample portion is acquired and a dark subset frame corresponding to a complementary (nonirradiated) sample portion is obtained. At 608, additional portions of the sample area can be selected for imaging and the acquisition process repeated. If completed, the sample subset frames and the dark subset frames are stitched together to form a sample frame and a dark frame at 612, 614, respectively, and at 616, the sample frame is compensated based on the dark frame to form a sample image. A particular arrangement of sample and dark frame values as corresponding arrays can be used, but other suitable mappings can be used.

**Example 7**

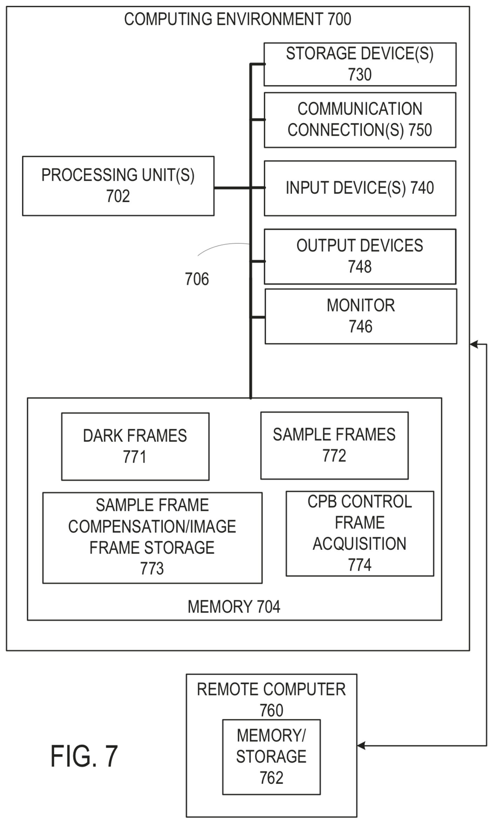

FIG. 7 and the following discussion are intended to provide a brief, general description of an exemplary computing environment in which the disclosed technology may be implemented. For example, one or more aspects of the CPB instrument controller and frame processing can be accomplished with this computing environment which can also be used to control a beam blanking system, control a charged particle microscope system, and/or perform any portions of the methods disclosed above.

Although not required, the disclosed technology is described in the general context of computer executable instructions, such as program modules, being executed by a personal computer (PC). Generally, program modules include routines, programs, objects, components, data structures, etc., that perform particular tasks or implement particular abstract data types. Moreover, the disclosed technology may be implemented with other computer system configurations, including handheld devices, tablets, multiprocessor systems, microprocessor-based or programmable consumer electronics, network PCs, minicomputers, mainframe computers, virtual machines, containerized applications, and the like. The disclosed technology may also be practiced in distributed computing environments where tasks are performed by remote processing devices that are linked through a communications network. In a distributed computing environment, program modules may be located in both local and remote memory storage devices. The disclosed systems can serve to control image acquisition and provide a user interface as well as serve as an image processor.

With reference to FIG. 7, an exemplary system for implementing the disclosed technology includes a general-purpose computing device in the form of an exemplary conventional PC 700, including one or more processing units 702, a system memory 704, and a system bus 706 that couples various system components including the system memory 704 to the one or more processing units 702. The system bus 706 may be any of several types of bus structures including a memory bus or memory controller, a peripheral bus, and a local bus using any of a variety of bus architectures. The exemplary system memory 704 can include read only memory (ROM) and random-access memory (RAM) and a basic input/output system (BIOS) containing the basic routines that help with the transfer of information between elements within the PC 700, can be stored in ROM.

The exemplary PC 700 further includes one or more storage devices 730 such as a hard disk drive for reading from and writing to a hard disk or solid-state drive which can be connected to the system bus 706 by a hard disk drive interface. Such devices and the associated computer readable media provide nonvolatile storage of computer-readable instructions, data structures, program modules, and other data for the PC 700. A number of program modules may be stored in the storage devices 730 including an operating system, multiple operating systems, virtual operating systems, one or more application programs, other program modules, and/or program data.

The exemplary PC 700 can include various devices configured for user interface. For example, a user may enter commands and information into the PC 700 through one or more input devices 740 such as a keyboard and a pointing device such as a mouse. For example, the user may enter commands to initiate image acquisition and/or to initiate one or more methods disclosed herein. Input devices are often connected to the one or more processing units 702 through a serial port interface that is coupled to the system bus 706 but may be connected by other interfaces such as a parallel port, universal serial bus (USB), or wired or wireless network connection. A monitor 746 or other type of display device may also be connected to the system bus 706 via an interface, such as a video adapter and can display, for example, one or more images of a sample or specimen prior to, subsequent to, and/or during performance of one or more methods disclosed herein.

As shown in FIG. 7, the memory 704 includes portions 771, 772 that store sample frames and dark frames, respectively, a portion 773 that stores computer-executable instructions for sample frame compensation and image frame storage, and a portion 774 that provides instructions for CPB control, blanking, frame acquisition, and other operations associated with the disclosed methods.

The PC 700 may operate in a networked environment using logical connections to one or more remote computers, such as a remote computer 760. In some examples, one or more network or communication connections 750 are included for wired or wireless communication as well as data acquisition and control such as digital-to-analog convertors and analog-to-digital convertors. The remote computer 760 may be another PC, a server, a router, a network PC, and/or a peer device or other common network node, and typically includes many or all of the elements described above relative to the PC 700, although only a memory storage device 762 has been illustrated in FIG. 7. The personal computer 700 and/or the remote computer 760 can be connected to a local area network (LAN) and a wide area network (WAN). Such networking environments are commonplace in offices, enterprise wide computer networks, intranets, and the Internet. The network connections shown are exemplary, and other means of establishing a communications link between the computers may be used.

### Example 8. CPB Imaging for Tomographic Reconstruction

The disclosed approaches are particularly useful in CPB tomographic imaging due to the relatively lengthy image acquisition process required to obtain the necessary large number of images to be combined. In some examples of CPB tomographic imaging, stroboscopic illumination of a rotating sample at random or other sequences of angles is used to acquire a sequence of frames to be used in tomographic reconstruction. A sample can be rotated at a uniform angular velocity, and random angular exposures can be established based on one or more series of angular values which can be generated as needed or retrieved from a computer readable storage such as memory. Angles can be specified based on a phase associated with rotation of a sample, a set of exposure times based on a sample rotation speed, generated randomly during image acquisition, or otherwise specified. The sample can be rotated at a fixed or variable velocity and stroboscopically irradiated while rotating. The stroboscopic irradiation can be at a fixed or variable pulse rate including at random times duration rotation. The irradiation angles can be determined prior to, during, or after irradiation and the irradiation angles can be a fixed or variable distribution of angles, including random angles. Dark frames can be acquired between stroboscopic pulses, or at times associated with sample rotations for which acquisition of sample frames is not needed. As discussed above, during dark frame acquisition, it is not necessary that pulsed CPB radiation be completely attenuated as compensation of sample frames by subtraction of a dark reference will still attenuate noise but with some reduction in signal frame magnitudes due to the non-zero CPB irradiation of the sample. For samples that are rotated in a single direction, dark frames can be acquired at every rotation at a fixed angle, such as an angle for which a sample frame is not to be acquired or at any other convenient angle.

In some examples, sample exposures are made using a constant sample rotation speed to produce uniformly spaced exposures for convenience, but non-uniform speeds such as monotonically increasing or decreasing speeds, or arbitrary increasing and decreasing rotation speeds can be used. With a uniform, constant rotation, samples can be acquired at random exposure angles with suitable pulse rates or pulse intervals. As discussed above, such random exposures can be based on random exposure times or rotation phases that can be stored or generated as needed. Alternatively, sample rotation can be at a variable speed such as a random speed, and exposure times can be separated by a constant delay.

### Example 9. Additional Examples

In addition to imaging for tomographic reconstruction the disclosed approaches can be useful for several other applications. For example, applications which require acquisitions which are long relative to the rate of change of dark noise. In some examples, the applications include navigating or searching over the sample. In some examples, the applications include image dynamic processing of the sample. In some examples, applications which require a very high dose relative to dose per time unit, which might be limited by either the CPB source intensity or camera characteristics and therefore accumulate for a long time.

In some examples, a subsequent set of one or more sample frames is acquired after a acquiring a predetermined number of sample frames in a prior set of one or more sample frames. In some examples, depending on user input, presetting, or other input, any of the parameters can vary. In some examples the number of samples in the first and/or second sets of one or more samples is dynamic, for example, depending on data quality, the size and/or the duration of the frame sets is adjusted on-the-fly during acquisition.

## Disclosure Clauses

In view of the above-described implementations of the disclosed subject matter, this application discloses the additional clauses enumerated below. It should be noted that one feature of a clause in isolation or more than one feature of the clause taken in combination and, optionally, in combination with one or more features of one or more further clauses are further clauses also falling within the disclosure of this application.

Clause 1 is a method comprising: acquiring a first set of one or more sample frames associated with a sample; compensating the first set of one or more sample frames based on a first dark reference to produce a first set of one or more compensated sample frames; acquiring a second set of one or more sample frames; after acquiring the first set of one or more frames, acquiring one or more dark frames, wherein the one or more dark frames are acquired before, after, or both before and after the acquisition of the second set of one or more sample frames; updating the first dark reference based on the one or more acquired dark frames to create a second dark reference; and compensating the second set of one or more frames based on the second dark reference to produce a second set of one or more compensated sample frames.

Clause 2 includes the subject matter of Clause 1, and further specifies that each sample frame of the first set of one or more sample frames and second set of one or more sample frames is acquired by detecting charged particles or electromagnetic radiation responsive to irradiation of the sample with a charged particle beam (CPB).

Clause 3 includes the subject matter of any of Clauses 1-2, and further specifies that the CPB comprises an electron beam.

Clause 4 includes the subject matter of any of Clauses 1-3, and further specifies that the first set of one or more sample frames and the second set of one or more sample frames are acquired at one or more tilt angles of the sample with respect to the CPB.

Clause 5 includes the subject matter of any of Clauses 1-4, and further includes combining the compensated first set of one or more sample frames and the compensated second set of one or more sample frames to create a compound image of the sample.

Clause 6 includes the subject matter of any of Clauses 1-5, and further specifies that the compound image comprises a tomographic reconstruction of the sample.

Clause 7 includes the subject matter of any of Clauses 1-6, and further includes continuously rotating the sample while acquiring first set of one or more sample frames and the second set of one or more sample frames.

Clause 8 includes the subject matter of any of Clauses 1-9, and further specifies that each sample frame of the first set of one or more sample frames, the second set of one or more sample frames, and the one or more acquired dark frames comprises a two-dimensional array of pixels.

Clause 9 includes the subject matter of any of Clauses 1-8, and further specifies that the acquiring the second set of one or more sample frames is performed after a acquiring a predetermined number of sample frames in the first set of one or more sample frames.

Clause 10 includes the subject matter of any of Clauses 1-9, and further specifies that the acquiring the second set of one or more sample frames is performed at a fixed time interval after acquisition of one or more of the sample frames of the first set of one or more sample frames.

Clause 11 includes the subject matter of any of Clauses 1-10, and further includes tracking a sample feature using the compensated first set of one or more sample frames and the compensated second set of one or more sample frames.

Clause 12 includes the subject matter of any of Clauses 1-11, and further includes: acquiring a second set of one or more dark frames after acquiring the second set of one or more sample frames; acquiring a third set of one or more sample frames; and compensating the third set of one or more sample frames based on at least one or more of the first set and second set of one or more dark frames.

Clause 13. A charged particle beam (CPB) imaging apparatus, including: a CPB source operable to irradiate a sample with a CPB; a beam blanker operable to selectively direct the CPB to the sample; and a detection system operable to acquire a sequence of frames that includes a first set of sample frames, a second set of sample frames, a first set of dark frames, and a second set of dark frames respectively, wherein the first set of sample frames and the second set of sample frames are associated with operation of the beam blanker to irradiate the sample with the CPB and the first set of dark frames and the second set of dark frames are associated with operation of the beam blanker to divert at least a portion of the CPB from the sample.

Clause 14 includes the subject matter of Clause 13, and further specifies that the beam blanker comprises a beam deflector and an aperture plate, and wherein the beam deflector selectively directs the CPB away from an aperture in the aperture plate.

Clause 15 includes the subject matter of any of Clause 13-14, and further includes a controller configured to control the beam blanker to produce the first set of frames, the second set of frames, the first set of dark frames, and the second set of dark frames.

Clause 16 includes the subject matter of any of Clauses 13-15, and further specifies that the controller is configured to: establish a first dark reference based on the first set of dark frames; update the first dark reference based on the second set of dark frames to create a second dark reference; compensate the first set of sample frames with the first dark reference to create a compensated first set of sample frames; and compensate the second set of frames with the second dark reference to create a compensated second set of sample frames.

Clause 17 includes the subject matter of any of Clauses 13-16, and further specifies that the controller is operable to produce a compound image by combining the compensated first set of sample frames with the compensated second set of sample frames.

Clause 18 includes the subject matter of any of Clauses 13-17, and further specifies that the controller is further operable to compute a tomographic reconstruction of the sample by combining the compensated first set of sample frames with the compensated second set of sample frames.

Clause 19 includes the subject matter of any of Clauses 13-18, and further specifies that the CPB source comprises an electron beam source and the CPB comprises an electron beam.

Clause 20 is a charged particle beam (CPB) imaging method, including: intermittently interrupting acquisition of sample frames based on radiation received from a sample responsive to a CPB to acquire one or more dark frames during each intermittent interruption; and establishing a sample image based on the sample frames and on one or more of the dark frames acquired during each of the intermittent interruptions.

Clause 21 includes the subject matter of Clause 20, and further specifies that the establishing the sample image comprises compensating a plurality of sets of sample frames based on respective sets of dark frames acquired during associated intermittent interruptions, wherein the sample image is established by combining the compensated sets of sample frames.

Clause 22 includes the subject matter of any of Clauses 20-21, and further specifies that the sample frames are acquired at one or more tilt angles of the sample with respect to the CPB.

In view of the many possible examples to which the principles of the disclosed technology may be applied, it should be recognized that the illustrated clauses are only preferred clauses and should not be taken as limiting,

**Claims**

1. A method comprising:

   acquiring a first set of one or more sample frames associated with a sample;
   compensating the first set of one or more sample frames based on a first dark reference to produce a first set of one or more compensated sample frames;
   acquiring a second set of one or more sample frames;
   after acquiring the first set of one or more frames, acquiring one or more dark frames, wherein the one or more dark frames are acquired before, after, or both before and after the acquisition of the second set of one or more sample frames;
   updating the first dark reference based on the one or more acquired dark frames to create a second dark reference; and
   compensating the second set of one or more frames based on the second dark reference to produce a second set of one or more compensated sample frames.

2. The method of claim 1, wherein each sample frame of the first set of one or more sample frames and second set of one or more sample frames is acquired by detecting charged particles or electromagnetic radiation responsive to irradiation of the sample with a charged particle beam (CPB).

3. The method of claim 2, wherein the first set of one or more sample frames and the second set of one or more sample frames are acquired at one or more tilt angles of the sample with respect to the CPB.

4. The method of claim 3, further comprising combining the compensated first set of one or more sample frames and the compensated second set of one or more sample frames to create a compound image of the sample.

5. The method of claim 4, wherein the compound image comprises a tomographic reconstruction of the sample.

6. The method of claim 3, further comprising continuously rotating the sample while acquiring first set of one or more sample frames and the second set of one or more sample frames.

7. The method of claim 1, wherein each sample frame of the first set of one or more sample frames, the second set of one or more sample frames, and the one or more acquired dark frames comprises a two-dimensional array of pixels.

8. The method of claim 1, wherein the acquiring the second set of one or more sample frames is performed after acquiring a predetermined number of sample frames in the first set of one or more sample frames or at a fixed time interval after acquisition of one or more of the sample frames of the first set of one or more sample frames.

9. The method of claim 3, further comprising tracking a sample feature using the compensated first set of one or more sample frames and the compensated second set of one or more sample frames.

10. The method of claim 3, further comprising:

    acquiring a second set of one or more dark frames after acquiring the second set of one or more sample frames;
    acquiring a third set of one or more sample frames; and
    compensating the third set of one or more sample frames based on at least one or more of the first set and second set of one or more dark frames.

11. A charged particle beam (CPB) imaging apparatus, comprising:

    a CPB source operable to irradiate a sample with a CPB;
    a beam blanker operable to selectively direct the CPB to the sample; and
    a detection system operable to acquire a sequence of frames that includes a first set of sample frames, a second set of sample frames, a first set of dark frames, and a second set of dark frames respectively, wherein the first set of sample frames and the second set of sample frames are associated with operation of the beam blanker to irradiate the sample with the CPB and the first set of dark frames and the second set of dark frames are associated with operation of the beam blanker to divert at least a portion of the CPB from the sample.

12. The CPB imaging apparatus of claim 11, further comprising a controller configured to control the beam blanker to produce the first set of frames, the second set of frames, the first set of dark frames, and the second set of dark frames.

13. The CPB imaging apparatus of claim 12, wherein the controller is configured to:

    establish a first dark reference based on the first set of dark frames;
    update the first dark reference based on the second set of dark frames to create a second dark reference;
    compensate the first set of sample frames with the first dark reference to create a compensated first set of sample frames; and
    compensate the second set of frames with the second dark reference to create a compensated second set of sample frames.

14. The CPB imaging apparatus of claim 13, wherein the controller is operable to produce a compound image by combining the compensated first set of sample frames with the compensated second set of sample frames.

15. The CPB imaging apparatus of claim 13, wherein the controller is further operable to compute a tomographic reconstruction of the sample by combining the compensated first set of sample frames with the compensated second set of sample frames.

FIG. 1

FIG. 2B

16x16 0s

16x16 30s

FIG. 2A

FIG. 2C

204

206

210 → $SF_1{}^1 \ldots SF_j{}^1$  $DF_1{}^1 \ldots DF_k{}^1$  $SF_1{}^2 \ldots SF_j{}^2$  $DF_1{}^2 \ldots DF_k{}^2$  $SF_1{}^3 \ldots SF_j{}^3$

$DR_0$  $\underbrace{\phantom{DF_1{}^1 \ldots DF_k{}^1}}_{DR_1}$  $\underbrace{\phantom{DF_1{}^2 \ldots DF_k{}^2}}_{DR_2}$

220 → $SF_1{}^1 \ldots SF_{j1}{}^1$  $DF_1{}^1 \ldots DF_{k1}{}^1$  $SF_1{}^2 \ldots SF_{j2}{}^2$  $DF_1{}^2 \ldots DF_{k2}{}^2$  $SF_1{}^3 \ldots SF_{j3}{}^3$

$DR_0$  $\underbrace{\phantom{DF_1{}^1 \ldots DF_{k1}{}^1}}_{DR_1}$  $\underbrace{\phantom{DF_1{}^2 \ldots DF_{k2}{}^2}}_{DR_2}$

230 → $DR_0$ [$SF^1$][reset][$DF^1$][$SF^2$][reset][[$DF^2$]  $\ldots$ [$DF^{(N-1)}$] [$SF^N$]

FIG. 2D

FIG. 3

FIG. 4A

400

```
┌─────────────────────────────────┐
│    SELECT CPB PULSE DURATION     │
│           AND TIMING             │
│              402                 │
└─────────────────────────────────┘
                 │
                 ▼
┌─────────────────────────────────┐
│  ACQUIRE INITIAL DARK FRAME OR   │
│ OTHERWISE ESTABLISH INITIAL DARK │
│            REFERENCE             │
│              404                 │
└─────────────────────────────────┘
                 │
                 ▼
┌─────────────────────────────────┐
│  APPLY CPB PULSE(S) AND ACQUIRE  │
│          SAMPLE FRAMES           │
│              406                 │
└─────────────────────────────────┘
                 │
                 ▼
┌─────────────────────────────────┐
│      ACQUIRE DARK FRAMES         │
│    DURING INTERPULSE PERIOD      │
│              408                 │
└─────────────────────────────────┘
                 │
                 ▼
         ◇ END ACQUISITION? ◇
               410
                 │
                 ▼
┌─────────────────────────────────┐
│  COMMUNICATE SAMPLE FRAMES AND   │
│ DARK FRAMES FOR COMPENSATION     │
│     AND IMAGE PRODUCTION         │
│              412                 │
└─────────────────────────────────┘
```

FIG. 4B

450

SELECT CPB PULSE DURATION
AND TIMING
452

ACQUIRE INITIAL DARK FRAME OR
OTHERWISE ESTABLISH INITIAL DARK
REFERENCE
454

APPLY CPB PULSE(S) AND ACQUIRE
SAMPLE FRAMES
456

ACQUIRE DARK FRAMES
DURING INTERPULSE PERIOD
458

COMBINE SAMPLE FRAMES AND DARK
FRAMES FOR COMPENSATION
AND IMAGE PRODUCTION
460

END ACQUISITION?
462

FIG. 5A

502

504

500

FIG. 5B

512

514

500

IRRADIATE SELECTED PORTION OF
SAMPLE ROI
602

IMAGE SELECTED PORTION OF SAMPLE
ROI TO SUBSET OF DETECTOR ARRAY
PIXELS
604

ACQUIRE SAMPLE SUBSET FRAME
ASSOCIATED WITH IRRADIATED SAMPLE
AREA AND DARK SUBSET FRAME
ASSOCIATED WITH COMPLEMENTARY
SAMPLE AREA
606

MORE
SAMPLE
ROI PORTIONS
608

SELECT PORTION OF
SAMPLE ROI
610

STITCH TOGETHER SAMPLE
SUBSET FRAMES TO FORM
SAMPLE FRAME
612

STITCH TOGETHER
SAMPLE SUBSET FRAMES
TO FORM DARK FRAME
614

COMPENSATE SAMPLE FRAME BASED
ON DARK FRAME
616

600

FIG. 6

COMPUTING ENVIRONMENT 700

STORAGE DEVICE(S)
730

COMMUNICATION
CONNECTION(S) 750

PROCESSING UNIT(S)
702

INPUT DEVICE(S) 740

706

OUTPUT DEVICES
748

MONITOR
746

DARK FRAMES
771

SAMPLE FRAMES
772

SAMPLE FRAME
COMPENSATION/IMAGE
FRAME STORAGE
773

CPB CONTROL
FRAME
ACQUISITION
774

MEMORY 704

REMOTE COMPUTER
760

MEMORY/
STORAGE
762

FIG. 7

# EP 4 722 700 A1

Europäisches
Patentamt

European
Patent Office

Office européen
des brevets

## EUROPEAN SEARCH REPORT

**Application Number**

EP 25 20 6691

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 465 781 B1 (NISHIMURA NORIMASA [JP] ET AL) 15 October 2002 (2002-10-15) <br> * figures * <br> * column 7, line 1 - line 19 * <br> * column 8, line 37 - line 68 * <br> ----- | 1-15 | INV. <br> G01N23/2251 <br> H01J37/26 |
| X,P | EP 4 513 525 A1 (JEOL LTD [JP]) 26 February 2025 (2025-02-26) <br> * paragraph [0095] - paragraph [0111] * <br> * paragraph [0036] - paragraph [0044]; figures * <br> * paragraph [0088] * <br> * paragraphs [0007], [0021] * <br> ----- | 1-3,8,10 | |
| | | | TECHNICAL FIELDS SEARCHED (IPC) <br><br> G01N <br> H01J |

The present search report has been drawn up for all claims

| Place of search | Date of completion of the search | Examiner |
|---|---|---|
| The Hague | 12 February 2026 | Eberle, Katja |

EPO FORM 1503 03.82 (P04C01)

## ANNEX TO THE EUROPEAN SEARCH REPORT
## ON EUROPEAN PATENT APPLICATION NO.

EP 25 20 6691

This annex lists the patent family members relating to the patent documents cited in the above-mentioned European search report.
The members are as contained in the European Patent Office EDP file on
The European Patent Office is in no way liable for these particulars which are merely given for the purpose of information.

12-02-2026

| Patent document cited in search report | | Publication date | Patent family member(s) | | Publication date |
|---|---|---|---|---|---|
| US 6465781 | B1 | 15-10-2002 | JP | 3805565 B2 | 02-08-2006 |
| | | | JP | 2000357483 A | 26-12-2000 |
| | | | US | 6465781 B1 | 15-10-2002 |
| EP 4513525 | A1 | 26-02-2025 | CN | 119492754 A | 21-02-2025 |
| | | | EP | 4513525 A1 | 26-02-2025 |
| | | | JP | 7768944 B2 | 12-11-2025 |
| | | | JP | 2025027786 A | 28-02-2025 |
| | | | US | 2025061606 A1 | 20-02-2025 |

EPO FORM P0459

For more details about this annex : see Official Journal of the European Patent Office, No. 12/82